# EUROPÄISCHE PATENTSCHRIFT

(11) **EP 1 341 737 B1**
(45) Veröffentlichungstag und Bekanntmachung des Hinweises auf die Patenterteilung: **16.03.2011**
(21) Anmeldenummer: 01985334.0
(22) Anmeldetag: 22.11.2001
(51) Int. Cl.: C04B 35/584, C04B 35/591

(54) **VERWENDUNG EINES SUBSTRATS AUF BASIS VON SILICIUMNITRID FÜR DIE HERSTELLUNG VON HALBLEITER BAUELEMENTE**
USE OF SILICON NITRIDE BASED SUBSTRATE FOR THE PRODUCTION OF SEMI-CONDUCTOR COMPONENTS
UTIILISATION D'UN SUBSTRAT A BASE DE NITRURE DE SILICIUM POUR FABRIQUER DES COMPOSANTS SEMI-CONDUCTEURS

(30) Priorität: 04.12.2000 DE 10060221
(43) Veröffentlichungstag der Anmeldung: 10.09.2003
(60) Teilanmeldung: 10179348.7
(73) Patentinhaber: H.C. Starck Ceramics GmbH & Co. KG, 95100 Selb (DE)
(72) Erfinder: WÖTTING, Gerhard, 96450 Coburg (DE); WODITSCH, Peter, 47800 Krefeld (DE); HÄSSLER, Christian, 47800 Krefeld (DE); STOLLWERCK, Gunther, 47800 Krefeld (DE)
(74) Vertreter: Peters, Frank M.
(86) Internationale Anmeldenummer: PCT/EP2001/013598
(87) Internationale Veröffentlichungsnummer: WO 2002/046121

(56) Entgegenhaltungen:
- EP-A- 0 831 077
- C. HEBLING ET AL.: "Dünnschichtsolarzellen aus kristallinem Silicium" SPEKTRUM DER WISSENSCHAFT, Nr. 2, - Februar 1999 (1999-02) Seiten 10-12, XP001040732 in der Anmeldung erwähnt

## Beschreibung

Die Erfindung betrifft die Verwendung eines Substrats auf Basis von Siliciumnitrid für Halbleiter-Bauelemente und Halbleiter-Bauelemente, die das Substrat enthalten.

Unter Substrat wird ein ebenes oder strukturiertes, flächiges Teil mit einer Dicke von vorzugsweise < 3 mm verstanden.

Die Photovoltaik wird derzeit von der Technologie des kristallinen Siliciums dominiert. Große polykristalline Siliciumblöcke mit Gewichten über 200 kg werden dabei in einzelne Scheiben zerteilt, die bei einer Dicke von ca. 300 µm Flächen von 10×10 cm² bis 15×15 cm² aufweisen. Aus diesen Scheiben lassen sich Solarzellen herstellen. Durch eine gut kontrollierte Kristallisation und angepasste Prozesse zur Herstellung von Solarzellen werden heute Wirkungsgrade von bis zu 15 % für Solarzellen, die in technischem Maßstab produziert werden, erreicht.

Nachteilig an dieser Art von Solarzellen ist jedoch, dass beim Zerteilen der polykristallinen Siliciumblöcke große Verluste an teurem kristallinem Silicium auftreten. Überdies müssen die Siliciumscheiben aus Stabilitätsgründen eine vergleichsweise große Dicke haben, was wiederum einen hohen Bedarf an kristallinem Silicium bedingt. Im Bestreben, kostengünstigere Alternativen zu dieser Art von Solarzellen bereitzustellen, wurden Dünnschichttechniken entwickelt, bei denen meist nur wenige µm dicke Halbleiterschichten verwendet werden. Die Dünnschichttechnologie bietet zusätzlich den Vorteil, dass bereits monolithisch verschaltete Solarzellen abgeschieden werden können und damit ein nachträgliches Verlöten der einzelnen Zellen entfällt.

Nachteile der Dünnschichttechnologien liegen derzeit vorrangig noch im Bereich der erreichbaren Wirkungsgrade auf großen, für Photovoltaikmodule relevanten Flächen im m²-Bereich.

Bei den für Dünnschichtsolarzellen eingesetzten Materialsystemen handelt es sich im einzelnen um Kupfer-Indium-Diselenid (CuInSe₂, CIS), Cadmium-Tellurid (CdTe), amorphes Silicium (a-Si), Galliumarsenid (GaAs) und kristallines Dünnschicht-Silicium.

Die Verwendung von GaAs erlaubt die Herstellung von Solarzellen höchster Wirkungsgrade (>30 %), ist aber aufgrund der eingesetzten Technologie und Materialien sehr kostenintensiv, so dass dieser Solarzellentyp auf Spezialanwendungen (z.B. Weltraum) limitiert bleibt. Für die Materialsysteme CdTe und CIS wurden ebenfalls hohe Wirkungsgrade (bis 18 %) auf kleinen Flächen demonstriert, wobei die Umsetzung dieser Wirkungsgrade auf großen Flächen von 0.1-1 m² bislang noch Schwierigkeiten bereitet. Durch Schichtinhomogenitäten sinkt der Wirkungsgrad hier bei entsprechend reduzierter Ausbeute auf 10-12 %. Nachteile des CdTe- und CIS-Systems sind zusätzlich in der im Vergleich zu Silicium wesentlich begrenzteren Verfügbarkeit der Materialien und der nicht geklärten Umweltbelastung beim massiven Einsatz dieser Solarzellentypen zu sehen.

Als die Materialsysteme mit der größten Verfügbarkeit und Umweltfreundlichkeit bleiben daher dünne Schichten aus amorphem und kristallinem Silicium. Aufgrund der defektreichen Struktur des amorphen Siliciums konnten mit Dünnschichtsolarzellen mit einer amorphen Siliciumschicht bislang nur Wirkungsgrade von 8 % (in industrieller Produktion auf großen Flächen) erreicht werden. Mit Dünnschichtsolarzellen mit einer defektärmeren dünnen Schicht aus kristallinem Silicium lassen sich hingegen die Vorteile des Materialsystems Silicium mit dem Potential für gute Wirkungsgrade verbinden.

So wird beispielsweise in Spektrum der Wissenschaft, Februar 1999, 10-12 eine Dünnschicht-Solarzelle mit einem Wirkungsgrad von 19,2 % beschrieben. Die photovoltaisch aktive kristalline Siliciumschicht wurde in einem komplexen Verfahren auf ein vorbehandeltes Siliciumsubstrat abgeschieden. Anschließend wurde auf der Oberfläche ein Muster aus umgekehrten Pyramiden erzeugt. Bei der beschriebenen Dünnschicht-Solarzelle handelt es sich jedoch nur um einen optimierten Labortyp. Die großtechnische Herstellung von Dünnschicht-Solarzellen dieses Typs ist bislang nicht gelungen. Es wird explizit ausgeführt, dass die Konstruktion einer Dünnschicht-Solarzelle aus kristallinem Silicium eine Reihe schwieriger Probleme aufwirft, die sich bisher erst teilweise und nur unter Laborbedindungen lösen ließen.

Das Hauptproblem bei der Entwicklung von Dünnschichtsolarzellen aus kristallinem Silicium besteht in der Lösung der Substratfrage. An das Substratmaterial werden dabei folgende Hauptanforderungen gestellt:
- Temperaturstabilität bis mindestens 1100°C (Abscheidetemperatur), vorzugsweise bis ca. 1400°C (Schmelzpunkt von Silicium).
- Thermischer Ausdehnungskoeffizient von Raumtemperatur bis zur Abscheidetemperatur ähnlich dem von Silicium, um thermische Spannungen zu unterdrücken und damit die Haftung der dünnen Siliciumschicht sicherzustellen.
- Geringster Verunreinigungseintrag aus dem Substratmaterial in die Siliciumschicht, insbesondere bezogen auf Übergangsmetalle. Der Wirkungsgrad von Solarzellen auf Basis von Silicium nimmt schon beim Vorhandensein von metallischen Verunreinigungen im ppba-Bereich deutlich ab.

Zusammengefasst ergibt sich die Anforderung der Abscheidbarkeit defektarmer Siliciumschichten zur Herstellung hocheffizienter Solarzellen, die zusammen mit der ebenso bedeutsamen Forderung nach einer großflächigen, kostengünstigen Herstellbarkeit und einer direkten Einsetzbarkeit der Substrate ohne kostenintensive Nachbehandlung bisher nur unzureichend erfüllt werden konnte. Untersucht wurden bisher z.B. Substratmaterialien aus Silicium selbst, Graphit und keramischen Materialien wie Mullit, Al₂O₃ SiC, und Si₃N₄ (Spektrum der Wissenschaft, Februar 1999, 10-12; Proc. of European Photovoltaic Solar Energy Conference, Glasgow, Mai 2000).

In EP 831 077 A1 ist eine Trägerscheibe für eine Solarzelle offenbart, die eine keramische Substratschicht auf Basis von reaktionsgebundenem Siliciumcarbid, eine Deckschicht aus kristallinem Silicium und gegebenenfalls eine zwischen diesen Schichten angeordnete Sperrschicht enthält. Dies ist jedoch eine stoffliche Beschränkung auf den Werkstoff SiC mit meist halbleitenden Eigenschaften. Auch muss zur Herstellung der Trägerscheibe die Reaktionsbindung und die Ausbildung der Siliciumdeckschicht in einem einzigen Wärmebehandlungsschritt durchgeführt werden, was die Möglichkeit, die Eigenschaften des Materials der Trägerscheibe gezielt einzustellen stark einschränkt. Es werden ferner keine Maßnahmen zur gezielten Einstellung des Wärmeausdehnungskoeffizienten (WAK) oder der elektrischen Leitfähigkeit ausgeführt, und keine Aussagen über die Qualität von Dünnschichtsolarzellen, die aus dieser Trägerscheibe hergestellt werden, gemacht.

EP 536 682 A2 beschreibt ein Halbleiter-Bauelement, beispielsweise eine Dünnschicht-Solarzelle, das einen Träger, Kontakte, sowie zumindest eine zwischen diesen vorhandene Halbleiterschicht und eine zwischen der Halbleiterschicht und dem Träger angeordnete Keimbildungsschicht aufweist. Der Träger kann aus beliebigem Material, vorzugsweise mit einem thermischen Ausdehnungskoeffizienten wie Silicium bestehen. Als geeigneter Träger wird beispielhaft Graphit genannt. Auf den Träger muss zunächst eine leitfähige Zwischenschicht, dann eine Keimbildungsschicht und schließlich die photovoltaisch geeignete Schicht aufgebracht werden. Nachteil an der Verwendung eines beliebigen Trägers ist, dass der Träger auf der der Keimbildungsschicht zugewandten Seite versiegelt oder zwischen Träger und Keimbildungsschicht eine versiegelnde Zwischenschicht aufgebracht werden muss. Es werden keine Angaben darüber gemacht, welche Wirkungsgrade mit entsprechend aufgebauten Dünnschichtsolarzellen erreicht werden können.

Die Aufgabe der vorliegenden Erfindung bestand darin, die Verwendung einer Substrats für Halbleiter-Bauelemente, insbesondere für Dünnschichtsolarzellen zur Verfügung zu stellen, auf dem sich defektarme Siliciumschichten zur Herstellung hocheffizienter Solarzellen abscheiden lassen, das großflächig und kostengünstig herstellbar ist und direkt ohne kostenintensive Nachbehandlung eingesetzt werden kann.

Im Bestreben, ein Substrat zur Verfügung zu stellen, das die genannten Forderungen erfüllt und durch Modifizierung von Zusammensetzung und/oder Herstellungsverfahren sehr breite Anpassungsmöglichkeiten an variierte und/oder weitere Forderungen ermöglicht, wurde überraschenderweise gefunden, dass sich ein Si₃N₄-basierendes Material, das bei seiner Herstellung eine Schwindung von < 5% und eine verbleibende offene Porosität von < 15 Vol.-% aufweist und aus den kristallinen Hauptphasen Si₃N₄, SiC und Si₂N₂O besteht, hervorragend als Substrat für Halbleiter-Bauelemente eignet. Die geringe Schwindung ermöglicht hierbei, ebene oder gezielt strukturierte Substrate ohne unkontrollierten Verzug und/oder sonstigen Schädigungen wie Rissbildung, Verwerfungen etc. zu erhalten.

Gegenstand der Erfindung ist demnach die Verwendung einer Substrats auf Basis von Siliciumnitrid für Halbleiter-Bauelemente, dadurch gekennzeichnet, dass das Substrat als kristalline Phasen Siliciumnitrid (Si₃N₄), Siliciumcarbid (SiC) und Siliciumoxynitrid (Si₂N₂O) enthält und der Gehalt an kristallinem Silicium ≤ 5 %, bezogen auf die Gesamtheit der vorliegenden kristallinen Phasen, die Schwindung bei der Herstellung < 5 % und die offene Porosität des Substrats < 15Vo1.% beträgt.

Vorzugsweise ist der Gehalt an kristallinem Silicium ≤ 3 %.

Unter kristallinen Phasen und kristallinem Silicium werden solche Phasen und solches Silicium verstanden, die mittels Röntgendiffraktometrie ermittelt werden. Das erfindungsgemäße Substrat läßt sich bei vergleichsweise niedrigen Temperaturen herstellen. Daher ist es möglich, ein breites Spektrum von Zusatzstoffen zur gezielten Beeinflussung oder Einstellung ganz spezifischer Eigenschaften zuzusetzen.

Werkstoffe auf der Basis von Si₃N₄, SiC und Si₂N₂O mit gegebenenfalls geringen Restgehalten an Silicium sind an sich schon bekannt. So beschreibt WO 00/32537 A2 einen Werkstoff, der durch Mischung von Silicium- und Si₃N₄-Pulver unter Zusatz einer organischen Siliciumverbindung, Formgebung dieser Mischung und thermischer Behandlung der resultierenden Formkörper hergestellt wird. Die thermische Behandlung wird dabei so ausgeführt, dass der Phasenbestand an Silicium < 1%, die lineare Schwindung < 5% und die verbleibende offene Porosität ≤ 13Vol.-% beträgt. Die Werkstoff-Zusammensetzung und Prozessführung ist dabei darauf ausgerichtet, hochtemparaturbeständige und Oxidations-resistente Werkstoffe und Bauteile, beispielsweise für Turbinen, Brennkammern oder zur Verarbeitung von Metallschmelzen zur Verfügung zu stellen. Es findet sich kein Hinweis, dass dieses Material als Substrat für Halbleiter-Bauelemente geeignet oder gar vorteilhaft wäre.

Die Werkstoffe eignen sich jedoch ausgezeichnet als Substrat für Halbleiter-Bauelemente, insbesondere da es durch entsprechende Wahl des Herstellverfahrens möglich ist, auf einfache Weise große flächige Substrate zu erzeugen. Dies führt zu essentiellen technischen und wirtschaftlichen Vorteilen, da die oft nötige Nachbehandlung des Substrats deutlich verringert oder sogar ganz überflüssig wird.

In einer besonderen Ausführungsform der Substrate enthalten diese Sinteradditive in einer Gesamtkonzentration von < 20 Gew.-%, die während der Herstellung eine flüssige Phase ausbilden und im Substrat als amorphe Sekundärphase oder als komplexere kristalline Nebenphasen vorliegen.

Prinzipiell eigen sich alle Sinteradditive, die üblicherweise Keramiken auf Basis von Siliciumnitrid zugesetzt werden. Vorzugsweise handelt es sich bei den Sinteradditiven um SiO₂, Erdalkali-Oxide, Oxide der Gruppe III B und IV B des Periodensystems, inklusive der Seltenen Erdoxide, V-, Nb-, Ta, Cr, Fe-, Co- und/oder Ni-Oxid, wobei die genannten Oxide einzeln oder im Gemisch und/oder in Kombination mit B₂O₃, Al₂O₃ und/oder TiO₂ eingesetzt werden können.

Es ist auch möglich, dass das Substrat Carbide, Nitride, Carbonitride, Oxinitride, Silicide und/oder Boride der Elemente Si, Al, Ti, Zr, Hf, V, Nb, Ta, Cr, Mo, W, Mn, Fe, Ca und/oder Ni in Konzentrationen < 10 Gew.-% berechnet als entsprechende Verbindung enthält, wobei der Gesamtanteil an diesen Bestandteilen 10 Gew.-%, vorzugsweise 5 Gew.-% nicht überschreitet.

In einer weiteren Ausführungsform kann das Substrat Carbide, Nitride, Carbonitride, Silicide und/oder Boride der Elemente Si, Ti, Zr, Hf, V, Nb, Ta, Cr, Mo, W, Mn und/oder Fe als weitere kristalline Hauptphase in einer Konzentration von ≥ 30 Vol.-%, vorzugsweise ≥ 35 Vol.-% enthalten, wobei das Substrat eine elektrische Leitfähigkeit von ≥ 0,1 S/m aufweist.

Die genannten Carbide, Nitride, Carbonitride, Oxinitride, Silicide und/oder Boride können im Substrat in ihrer eingebrachten Form oder als komplexere kristalline Nebenphasen vorliegen. Durch diese Zusätze lässt sich beispielsweise die Haftung von auf dem Substrat aufgebrachten Schichten beeinflussen. Auch der WAK von Dünnschichtsolarzellen, die ausgehend vom erfindungsgemäßen Substrat hergestellt werden, die Absorption von sichtbaren, infraroten und ultravioletten Lichtstrahlen in solchen Dünnschichtsolarzellen und die elektrische Leitfähigkeit ist über diese Zusätze beeinflussbar.

Die genannten Carbide, Nitride, Carbonitride, Oxinitride, Silicide und/oder Boride können beispielsweise als anorganische Fasern, Whisker, Platelets oder Partikel eingebracht werden und/oder im Substrat in dieser Form vorliegen.

Es ist auch möglich, dass das Substrat Kohlenstoff-Fasern enthält, die im Substrat als solche vorliegen oder teilweise oder vollständig zu komplexeren Verbindungen abreagiert sind.

Das Substrat wird hergestellt in einem Verfahren, wobei die Ausgangsmischung intensiv gemischt, durch Pressen, Schlickergießen, Warmpressen, Extrudieren oder Foliengießen geformt, in inerter Atmosphäre vernetzt und pyrolisiert und anschließend nitridiert wird.

Gegebenenfalls kann nach der Nitridierung noch eine Sinterung zur weiteren Verdichtung folgen.

Bei der Ausgangsmischung handelt es sich beispielsweise um eine Mischung von Silicium, Siliciumnitrid und einem Silicium-organischen Polymer, wobei der Anteil der einzelnen Mischungskomponenten in einem vergleichsweise weiten Rahmen variieren kann. So kann die Ausgangsmischung 15-90 Gew.-% Silicium, 5 bis 60 Gew.-% Siliciumnitrid und 5 bis 60 Gew.-% des Silicium-organischen Polymers, vorzugsweise Polysiloxan und/oder Polycarbosilan und/oder Co-Polymere dieser Verbindungen, enthalten. Si-Gehalte unter 15 Gew.-% und Si₃N₄-Gehalte über 60 Gew.-% führen dazu, dass die Porositätsverminderung, resultierend aus der Nitridierung des Si zu Si₃N₄ nicht mehr ausreicht, um einen Werkstoff mit einer offenen Porosität <15 Vol.-% zu erhalten. Dies wirkt sich negativ auf die mechanischen Eigenschaften des Werkstoffs aus. Si-Gehalte >90 Gew.-% ermöglichen nur noch geringe Konzentrationen an Si₃N₄-Pulver und Silicium-organischem Polymer, wodurch sich der angestrebte Phasenbestand, der für die positiven Eigenschaften des Werkstoffes verantwortlich ist, nicht mehr einstellt. Dies begründet auch die spezifizierten Untergrenzen von ≥5 Gew.-% für das Si₃N₄-Pulver und die organische Siliciumverbindung. Die Obergrenze für das Silicium-organische Polymer ist mit 60 Gew.-% festgelegt. Noch höhere Gehalte würden bei der Pyrolyse zu hohen Schwindungswerten und zu einer unerwünscht hohen offenen Porosität führen.

Die eingesetzten Silicium-organischen Polymere können zusätzlich Heteroatome, wie beispielsweise B, Ti, Zr und/oder A1 enthalten, die nach der Pyrolyse des Silicium-organischen Polymers mit Matrixbestandteilen oder der Gasatmosphäre zu den entsprechenden Oxiden, Carbiden, Nitriden und/oder Carbonitriden reagieren. Die mit diesen Reaktionen meist verbundenen Volumenzunahmen fördern das Erzielen der erfindungsgemäßen geringen offenen Porosität des Werkstoffes von <15 Vol.-%. Andererseits ermöglichen diese Neubildungen die Einstellung ganz spezifischer Eigenschaften z.B. bezüglich der elektrischen und/oder tribologischen Eigenschaften und/oder des Benetzungsverhaltens gegenüber Flüssigkeiten, wie z.B. Schmierstoffen oder (metallischen) Schmelzen.

Zur Einstellung spezifischer Eigenschaften ist es auch möglich, entsprechende Inertstoffe, wie z.B. BN, TiN, TiB₂ oder MoSi₂, bereits der Ausgangsmischung zuzusetzen. Hierfür sind eine Vielzahl von Stoffen vorstellbar, sofern sie unter den Reaktionsbedingungen in Gegenwart der Basisstoffe thermodynamisch stabil sind und weder das Erzielen des angestrebten Phasenbestandes beeinträchtigen noch durch Reaktion ihre spezifischen Eigenschaften verlieren.

In die Rohstoffmischungen können weiterhin vorteilhaft Komponenten, insbesondere Carbide, Nitride, Carbonitride, Oxinitride, Silicide und/oder Boride eingebracht werden, die in Form von Fasern, als Kurz- oder Langfaser, Whisker, Platelets oder Partikel eine Verstärkung der Werkstoffe bewirken. Um die erfindungsgemäß vorteilhafte geringe offene Porosität von <15 Vol.-% zu erreichen, können hierbei Nachinfiltrationen mit der organischen Siliciumverbindung und zusätzliche Pyrolyseschritte notwendig werden.

Vorzugsweise liegen die Ausgangssubstanzen in Pulverform vor. Als Silicium-Pulver werden dabei vorteilhaft Pulverqualitäten mit mittleren Korngrößen <20 µm eingesetzt. Als Siliciumnitrid-Pulver sind vorteilhaft Pulverqualitäten mit mittleren Korngrößen <3 µm geeignet.

Als Silicium-organisches Polymer können vorteilhaft Polysiloxane, Polysilazane oder Polycarbosilane oder Copolymere dieser Verbindungen zum Einsatz gelangen. Neben Silicium können diese Verbindungen Kohlenstoff, Stickstoff, Wasserstoff und/oder Sauerstoff, sowie weitere Heteroatome wie z.B. Bor, Titan, Zirkonium oder Aluminium enthalten.

Die verwendeten Silicium-organischen Polymere besitzen zum einen die Funktion eines Bindemittels. Dadurch wird es möglich, die Ausgangsmischung ohne Zugabe weiterer organischer Zusätze beispielsweise durch Foliengießen direkt zu flächigen Substraten zu formen. Andererseits werden sie durch Pyrolyse in inerter Atmosphäre zu keramischen Phasen und Reaktanten abgebaut und dadurch in die Gefügeausbildung des Werkstoffes einbezogen.

Somit werden beim Verfahren die Silicium-organischen Polymere pyrolisiert, und im nachfolgenden Schritt der Nitridierung entsteht durch einen komplexen Reaktionsverlauf, der zum einen die Nitridierung des Silicium-Pulvers und zum anderen die Reaktion der Pyrolyseprodukte der Silicium-organischen Verbindungen umfasst, ein mehrphasiger Werkstoff, der als röntgenographisch nachweisbare kristalline Phasen Siliciumnitrid (Si₃N₄), Siliciumcarbid (SiC) und Siliciumoxynitrid (Si₂N₂O), sowie gegebenenfalls restliches unreagiertes Si enthält.

Die intensive Mischung und die Formgebung der Ausgangsmischung zu Substraten kann nach verschiedenen Methoden durchgeführt werden. Die einfachste Ausführungsform ist hierbei, die Rohstoffe Si-Pulver, Si₃N₄-Pulver und das bei Raumtemperatur als Feststoff vorliegende Si-organische Polymer intensiv trocken zu mischen, gegebenenfalls unter Hinzufügen eines organischen, H₂O-freien Pressöls, die Mischung z.B. über ein Sieb mit der Maschenweite 150 µm zu sieben und auf einer mechanischen Presse das gewünschte Substrat zu formen. Auch weitere, im folgenden beschriebenen Formgebungsverfahren sind nach dieser Trockenmischung möglich.

Eine bessere Homogenität des resultierenden Substrats ist erzielbar, wenn die Mischung als Nassmahlung erfolgt unter Verwendung eines organischen, wasserfreien Lösungsmittels, in dem sich das Silicium-organische Polymer löst. Diese Suspension wird mit geeigneten an sich bekannten Verfahren wie beispielsweise Rotationsverdampfer, Sprühtrockner etc. getrocknet, wiederum z.B. <150 µm gesiebt und nach dem oben beschriebenen Pressverfahren oder einem der im weiteren beschriebenen Formgebungsverfahren zum Substrat-Rohling geformt.

Eine weitere Möglichkeit der Herstellung der Ausgangsmischung stellt das Warmkneten dar. Hierbei werden die festen Ausgangsstoffe in einem geeigneten Mischaggregat, beispielsweise einem beheizbaren mechanischen Kneter unter ständiger Bewegung auf eine Temperatur oberhalb des Schmelzpunkts der Silicium-organischen Komponente erwärmt, wodurch sich eine teigige Konsistenz einstellt. Nach Erreichen der teigigen Konsistenz wird unter Fortführung des Knetvorgangs die Beheizung beendet, wodurch die teigige Rohstoffmischung in eine pulverige Beschaffenheit überführt wird, und nach Siebung über ein Sieb beispielsweise mit der Maschenweite 150 µm für die nachfolgende Formgebung des Substrats einzusetzen ist.

Zur Überführung der erzeugten Ausgangsmischungen in das geformte Substrat können neben dem genannten Trockenpressen beispielsweise die folgenden weiteren Verfahren eingesetzt werden:
- das Warmpressen, bei dem die Ausgangsmischung in eine Pressmatrize eingefüllt wird, die selbst oder indirekt beheizbar ist. Durch Beheizung wird das Rohstoffgranulat auf eine Temperatur über den Schmelzpunkt des Silicium-organischen Polymers erwärmt und dann der benötigte Verformungsdruck aufgegeben oder die Verdichtung soweit geführt, dass die erwünschte Formlingsdicke erhalten wird (weggesteuert). Nach der Verformung wird das Gesamtsystem abgekühlt, wodurch eine Verfestigung des geformten Substrates erfolgt und dieses ohne Verformung der Presse entnommen werden kann.
- das Extrudieren, wobei das trockene Rohstoffgranulat in einer an sich bekannten Formgebungsmaschine, beispielsweise einem Schneckenextruder unter Durchmischung auf eine Temperatur über den Schmelzpunkt des Silicium-organischen Polymers erwärmt und gleichzeitig gegen eine schlitzförmige Düse gefördert wird, die die wunschgemäße Breite und Dicke des Substrats aufweist. Nach Austritt aus der Düse wird das geformte Material auf ein bezüglich der Extrusionsgeschwindigkeit synchronisiertes ebenes Band abgelegt, auf dem das Substratmaterial erkaltet und dadurch verfestigt, sodass es anschließend geschnitten und abgenommen werden kann.
- das Foliengießen, bei dem bevorzugt organische Suspensionen aus den Ausgangsstoffen Silicium, Siliciumnitrid und dem Silicium-organischem Polymer in einem organischen Lösungsmittel zum Einsatz kommen, wobei das Silicium-organische Polymer im organischen Lösungsmittel löslich ist. Bei dieser Technik fließt die Suspension aus einem Vorratsbehälter über ein Schneidensystem kontinuierlich und in kontrollierter Dicke auf eine ebene Bank oder ein ebenes Laufband aus. Das Laufband durchläuft Trockeneinrichtungen, die zum Abdampfen des Lösungsmittels und damit zur Trocknung und Verfestigung der Suspension führen, so dass das erkaltete Substratmaterial schließlich geschnitten und abgenommen werden kann.

Vorzugsweise erfolgt die Formgebung der Ausgangsmischung durch Foliengießen.

Bei der Formgebung mittels Foliengießen ist es beispielsweise auch möglich, dass die Feststoff-Suspension neben dem Silicium-organischen Polymer weitere organische Zusätze, wie sie für das Foliengießen üblich sind enthält. Beispielsweise seien Methylethylketon, Polyvinylbutyral, Dibutylphthalat genannt.

Das Verfahren des Foliengießens ist in der Keramik an sich bekannt zur Herstellung von Al₂O₃-, AlN- und sonstiger Substrate, wobei allerdings zur Verfestigung der Suspensionen gezielt organische Polymere zugegeben und nachfolgend, da sie sich im allgemeinen nicht zu Bestandteilen des Werkstoffes pyrolysieren lassen, vollständig ausgetrieben werden müssen. Einen solchen Prozess beschreibt z.B. Y.W. Kim (Mater. Res. Soc. Symp. Proc., 1993, Vol. 287, S. 265 - 270) für einen Si₃N₄-Werkstoff mit Y₂O₃ und Al₂O₃ als Sinterhilfsmittel. Hierbei wird in einem organischen Lösungsmittel ein organisches Polymer gelöst, das die Dispergierung der Feststoffe und deren Verfestigung zu einem handhabbaren Substrat beim Abdampfen des Lösungsmittels bewirkt. Vor der weiteren Verarbeitung, in diesem Fall durch Sintern, muss dieses Polymer rückstandsfrei ausgebrannt werden.

Im Gegensatz dazu muss bei der Herstellung der Substrate mittels Foliengießen das verwendete Silicium-organische Polymer nicht ausgetrieben werden. Seine Zersetzungsprodukte reagieren zu Si₃N₄, SiC und/oder Si₂N₂O ab, die integrale Bestandteile des erfindungsgemäßen Substrats sind. Es zeigt sich überraschenderweise, dass eine Mischung aus organischem Lösungsmittel, Silicium-organischem Polymer und pulverförmigem Feststoff (Silicium, Siliciumnitrid und gegebenenfalls gewünschte Zusätze) alleine oder gegebenenfalls durch Zusatz der oben genannten weiteren organischen Zusätze bei ausreichender Homogenisierung auf eine Viskosität eingestellt werden kann, die die Verarbeitung der Mischung mittels Foliengießen erlaubt. Die Bindekraft des Silicium-organischen Polymers nach Abdampfen des organischen Lösungsmittels reicht aus, handhabbare Rohsubstrate zu erhalten und diese der weiteren Verarbeitung zuzuführen.

Dass sich eine Mischung aus organischem Lösungsmittel, Silicium-organischem Polymer und pulverförmigem Feststoff (Silicium, Siliciumnitrid und gegebenenfalls gewünschte Zusätze) auch ohne Zugabe weiterer organischer Polymere mittels Foliengießen zu flächigen Substraten der erfindungsgemäßen Zusammensetzung verarbeiten lässt, ist überraschend. Die verfahrenstechnischen Vorteile, die damit verbunden sind, sind bereits oben beschrieben.

Nach dem Formgebungsprozess können die geformten Substrate beispielsweise bei Temperaturen ≤ 250°C zur Unschmelzbarmachung des Silicium-organischen Polymers vernetzt, bei Temperaturen ≤ 1200°C pyrolisiert und anschließend bei Temperaturen ≤ 1500°C nitridiert werden.

Die Nitridierung erfolgt in stickstoffhaltiger Gasatmosphäre. Neben Stickstoff kann das Reaktionsgas zusätzlich Wasserstoff- und/oder Ammoniakgas enthalten. Die Nitridierungsreaktion kann sowohl unter Normaldruck als auch unter erhöhtem Gasdruck, vorzugsweise von 1 bis 100 bar, erfolgen. Die Maximaltemperaturen für diese Nitridierungsreaktion liegen vorteilhaft bei 1300 bis 1600°C. Der Temperatur-Zeitverlauf für die Nitridierungsreaktion ist an die jeweiligen spezifischen Bedingungen, wie z.B. Ofengröße und Bauteilvolumen, anzupassen.

Eine spezielle Ausführungsform der Nitridierung stellt das Betreiben dieses Prozesses unter erhöhtem N₂-Druck dar. Dadurch kann die Reaktionsgeschwindigkeit beschleunigt, der Umsetzungsgrad des Siliciums zu Si₃N₄ erhöht und die gesamten Prozesszeiten verkürzt werden, woraus sich deutliche wirtschaftliche Vorteile ergeben.

Vorzugsweise wird die Nitridierung bei Temperaturen < 1500°C unter N₂-Normaldruck, in einer speziellen Ausführung bei N₂-Drucken zwischen 1 bis 100 bar durchgeführt.

Bei Vernetzung, Pyrolyse und Nitridierung werden vorteilhafterweise Aufheizgeschwindigkeiten ≤ 100K/h gewählt.

Diese Prozessschritte finden bevorzugt in inerter Atmosphäre statt, beispielsweise in Gegenwart von Stickstoff.

Eine weitere spezielle Ausführungsform sieht eine Sinterung nach der Nitridierung vor, die bei Temperaturen ≤ 1800°C unter 1-100 bar N₂ bzw. bei Temperaturen > 1800°C unter erhöhtem N₂-Druck von 10 bis 2000 bar stattfinden kann.

Die Prozessschritte Vernetzung, Pyrolyse, Nitridierung und gegebenenfalls Sinterung können in einem einzigen geeigneten Ofen ausgeführt werden, vorteilhafter ist jedoch die Verwendung verschiedener, jeweils für die entsprechenden Temperaturbereiche optimierter Ofenanlagen.

Die Substrate können vielseitig eingesetzt werden. Sie werden zur Herstellung von Halbleiter-Bauelementen verwendet. Insbesondere eignen sich die erfindungsgemäßen Substrate zur Herstellung von Dünnschichtsolarzellen.

Dazu werden beispielsweise zunächst eine oder mehrere Siliciumschichten auf dem Substrat abgeschieden. Danach kann das beschichtete Substrat durch nachfolgende Prozeßschritte (z.B. Diffusion, Implantation, Oxidation) bzw. das Aufbringen von Leiterbahnen zu Halbleiter-Bauelementen, bevorzugt zu Dünnschichtsolarzellen weiterprozessiert werden.

Es ist jedoch auch möglich, die Substrate für spezielle Anwendungen in der Elektronik, Optik sowie dem allgemeinen Maschinen- und Apparatebau einzusetzen.

Gegenstand der Erfindung sind weiterhin Halbleiter-Bauelemente, die ein erfindungsgemäßes Substrat enthalten. Vorzugsweise handelt es sich bei dem Halbleiter-Bauelement um eine Dünnschicht-Solarzelle.

Zur Herstellung der erfindungsgemäßen Halbleiter-Bauelemente kann beispielsweise so vorgegangen werden, dass auf dem Substrat eine oder mehrere kristalline Siliciumschichten mittels chemischer Gasphasenabscheidung (CVD) oder Flüssigphasenepitaxie (LPE) abgeschieden werden. Die Substrattemperaturen bei der Abscheidung durch CVD liegen beispielsweise zwischen 900°C und 1300°C, vorzugsweise zwischen 1100°C und 1200°C. In einem CVD-Reaktor wird in bekannter Art und Weise eine Mischung aus Trichlorsilan oder Silan mit einem Dotiergas beispielsweise enthaltend Diboran, Boran, Aluminium-haltige und/oder Galliumhaltige metallorganische Verbindungen verdünnt in Wasserstoff über das Substrat geleitet. Die Wachstumsgeschwindigkeit der Schichten beträgt 1-10 µm/min.

Die Abscheidetemperaturen der LPE liegen beispielsweise bei 500°C bis 1000°C, vorzugsweise bei 800°C bis 1000°C. Hier wird eine Metallschmelze angereichert mit Silicium und gewünschten Dotiermetallen auf das Substrat aufgebracht und es erfolgt ein Silicium-Schichtwachstum aus der Schmelze. Die Korngröße beträgt bei beiden Abscheideverfahren üblicherweise nur wenige 10 µm.

Da so eine feinkristalline Siliciumschicht nicht für Solarzellen geeignet ist, muss die Korngröße vergrößert werden. Das geschieht üblicherweise mit einem Flüssigphasen-Zonenschmelzverfahren. Dazu schmilzt man die Keimschicht beispielsweise bei ca. 1420°C in einem schmalen Streifen bis zur Keramikoberfläche auf und zieht die flüssige Zone gleichmäßig über die Probe hinweg. Nach dem Entstehen von Kristallkeimen durch spontane Nukleation findet so ein laterales Überwachsen der amorphen Zwischenschicht statt. Aus der feinkristallinen Schicht wird eine Schicht mit großen Körnern von einigen Millimetern Breite und einigen Zentimetern Länge.

Es ist auch möglich, dass zwischen dem Substrat und den Siliciumschichten eine oder mehrere zusätzlichen Schichten aufgebracht werden, sogenannte Sperrschichten. Vorzugsweise handelt es sich bei den zusätzlichen Schichten um Siliciumnitrid-, Siliciumoxid- oder Siliciumcarbidschichten oder eine Kombination der Schichten. Das Aufbringen dieser zusätzlichen Schichten erfolgt dabei in an und für sich bekannter Weise. Es kann beispielsweise durch plasmaunterstützte chemische Gasphasenabscheidung erfolgen. Die Substrattemperatur liegt dabei beispielsweise zwischen 200°C und 800°C, vorzugsweise zwischen 300°C und 400°C. Zur Herstellung einer Siliciumnitridschicht wird Silan und Stickstoff im Plasma über die Probe geleitet, zur Herstellung von Siliciumoxid Silan und Lachgas.

Das Aufbringen der Zwischenschichten dient einerseits dazu, zu verhindern, dass Verunreinigungen aus dem Substrat in die photovoltaisch aktive Schicht gelangen, andererseits erlaubt es, die Substrateigenschaften besser an die Eigenschaften der abgeschiedenen Siliciumschichten, beispielsweise Leitfähigkeit, Haftung, Diffusionsbarriere anzupassen. Bei Einsatz der erfindungsgemäßen Substrate kann die Anpassung der Substrateigenschaften an die Eigenschaften der Siliciumschichten jedoch auch sehr einfach durch Einstellung der Substrateigenschaften selbst erfolgen, da durch Variation der Zusammensetzung des Substrats und dem gezielten Zusatz geeigneter Stoffe die Substrateigenschaften in weiten Grenzen variiert werden können.

Aus dem beschichteten Substrat lassen sich dann in bekannter Weise Halbleiter-Bauelemente, insbesondere Dünnschichtsolarzellen herstellen. Beispielsweise wird dabei so vorgegangen, dass in die Bor-dotierte Siliciumschicht Phosphor eindiffundiert wird. Das geschieht üblicherweise bei einer Diffusionstemperatur von 700°C bis 1000°C, vorzugsweise bei 800°C bis 850°C in einem POCl₃ Gasstrom in einem Diffusions-Rohrofen. Nach der Diffusion muss das entstandene Phosphorglas mit einer Flusssäure-haltigen Ätzmischung entfernt werden. Danach wird eine Antireflexschicht bestehend aus Titandioxid und/oder Magnesiumfluorid oder Siliciumnitrid in einer Vakuumaufdampfanlage oder einer plasmaunterstützten chemischen Gasphasenabscheidung aufgebracht. Andere Auftragsmethoden wie Sprühen, Rakeln oder dergleichen sind auch möglich.

Anschließend werden Kontakte aufgebracht. Wird ein isolierendes Keramik-Substrat verwendet, werden die Kontakte auf die Vorderseite des beschichteten Substrats aufgebracht, wird ein leitfähiges Keramik-Substrat verwendet, auf Vorder- und Rückseite. Zum Aufbringen der Kontakte werden metallhaltige Pasten aufgedruckt oder Metalle aufgedampft, so dass auf der Vorderseite ein kammförmiges Gitter aus Kontakten entsteht, während die Rückseite vollflächig oder in Gitterform bedruckt werden kann. Die Kontakte werden anschließend bei einer Temperatur von beispielsweise 500°C bis 1000°C, vorzugsweise von 650°C bis 750°C eingebrannt, um einen niederohmigen Übergang zwischen Halbleiter und Metall bzw. Keramik und Metall zu ermöglichen.

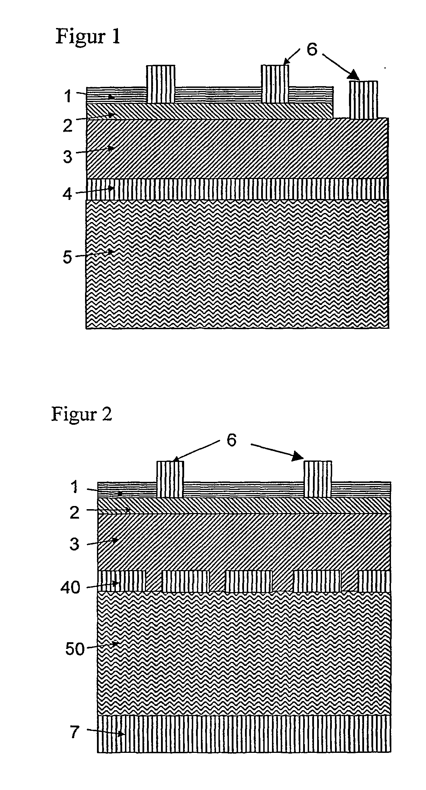

Der Aufbau einer Dünnschichtsolarzelle auf Basis eines isolierenden Keramik-Substrats ist schematisch in Figur 1 wiedergegeben. Auf dem isolierenden Keramik-Substrat (5) befindet sich eine Sperrschicht (4). Es folgt eine Bor-dotierte Schicht (3), eine Phosphor-dotierte Schicht (2) und schließlich eine Antireflexschicht (1). Die Kontakte sind als Vorderseitenkontakte (6) ausgebildet, wobei sowohl eine Kontaktierung der Bor-dotierten Schicht (3), als auch der Phosphor-dotierten Schicht (2) erfolgt.

Der Aufbau einer Dünnschichtsolarzelle auf Basis eines leitfähigen Keramik-Substrats ist schematisch in Figur 2 wiedergegeben. Auf dem leitfähigen Keramik-Substrat (50) ist eine perforierte Sperrschicht (40) aufgebracht. Es folgt eine Bor-dotierte Schicht (3), eine Phosphor-dotierte Schicht (2) und schließlich eine Antireflexschicht (1). Die Kontakte sind als Vorderseitenkontakte (6) und Rückseitenkontakt (7) ausgebildet, wobei die Vorderseitenkontakte (6) auf der Phosphor-dotierten Schicht (2) aufgebracht sind.

Die auf Basis des erfindungsgemäßen Substrats hergestellten Dünnschichtsolarzellen zeichnen sich durch hohe Wirkungsgrade von beispielsweise 9.4 % aus. Zudem können die Dünnschichtsolarzellen auch im großtechnischen Maßstab kostengünstig hergestellt werden, da sich die erfindungsgemäßen Substrate, insbesondere durch das Foliengießen sehr einfach in der benötigten flächigen Form geeigneter Größe erhalten lassen.

Anhand der folgenden Beispiele wird die Erfindung weiter erläutert. Die Beispiele geben jedoch lediglich einzelne Ausführungsformen wieder und sollen nicht als Einschränkung des der Erfindung zugrunde liegenden Gedankens verstanden werden.

### Beispiele

### Beispiel 1 (Verzleichsbeispiel)

1000 g Silicium-Pulver der mittleren Teilchengröße 3 µm, z.B. HCST Grade A10 der Firma H.C. Starck GmbH & Co KG und 500 g eines Methylpolysiloxans, z.B. NH2100 der Firma Nünchritz, wurden in Isopropanol unter Einstellen eines Feststoffgehalts von 30 Gew.-% in einer Mahltrommel mit Si₃N₄-Mahlkugeln auf einem Rollenbock 10 h gemischt, die Mahlkugeln abgetrennt und das Lösungsmittel Isopropanol abdestilliert. Das resultierende getrocknete Material wurde in einem Trockenschrank an Luft bei max. 80°C getrocknet und wiederum in einer Mahltrommel mit Si₃N₄-Mahlkugeln auf einem Rollenbock pulverisiert. Es entstand staubförmiges Material, das über ein Sieb mit der Maschenweite 100 µm abgesiebt wurde. Der Siebdurchgang wurde auf einer Achsialpresse in einer Stahlmatrize mit Pressdrucken ≥ 10 kN/cm² zu Substraten von 100 x 100 mm Fläche und ca. 2 mm Dicke verpresst. Diese Substrate wurden durch Aufheizen mit bis zu 3 K/min auf ca. 250°C unter N₂-Spülung vernetzt, durch weiteres Aufheizen auf 900°C in 1 bar N₂ pyrolysiert und durch Fortführung dieses Aufheizens bis 1450°C in 1 bar N₂ nitridiert.

An den so hergestellten, verfestigten Substraten wurde die Gewichts- und Dimensionsänderung, die Dichte (Archimedes-Prinzip nach H₂O-Sättigung) die offene Porosität (und die Porengrößenverteilung) durch Hg-Druckporosimetrie, sowie durch Röntgenbeugung der Bestand an kristallinen Phasen ermittelt.

Die an diesem Substrat ermittelten Kennwerte sind in Tabelle 1 zusammengestellt. Während die Schwindung und die kristallinen Hauptphasen den Erfindungskriterien entsprechen, liegt die offene Porosität deutlich über dem Grenzwert von 15 Vol.-% und der Phasenbestand an kristallinem Silicium über 5%.

Es wurden Beschichtungsexperimente zur Herstellung von Dünnschichtsolarzellen durchgeführt. Dabei wurde wie in Beispiel 7 beschrieben eine SiO₂-Si₃N₄-SiO₂ Sperrschicht auf das Substrat aufgebracht. Anschließend wurde eine Silicium-Keimschicht mit CVD aufgebracht. Beim anschließenden Flüssigphasen-Zonenschmelzen kam es zu Reaktionen zwischen den Beschichtungssubstanzen und dem Substratmaterial und, dadurch bedingt, zu einer schlechten Haftung und/oder zu Schädigungen der Beschichtung. Nach Beispiel 1 hergestellte Substrate sind folglich zur Herstellung von Halbleiter-Bauelementen nicht geeignet.

### Beispiel 2a

900 g Silicium-Pulver der mittleren Teilchengröße 3 µm, z.B. HCST Grade A10 der Firma H.C. Starck GmbH & Co KG, 500 g eines Methylpolysiloxans, z.B. NH2100 der Firma Nünchritz und 600 g Si₃N₄-Pulver mit einer mittleren Teilchengröße von 0,7 µm und einem N-Gehalt von >38 Gew.-%, z.B. HCST-M11, wurden wie in Beispiel 1 beschrieben aufbereitet. Die Formgebung zur gleichen Substratgröße erfolgte jedoch durch Warmpressen bei 160°C. Die weitere Verarbeitung wurde analog Beispiel 1 ausgeführt. Die resultierenden Kennwerte sind in Tabelle 1 zusammengestellt.

Es wurden Beschichtungsexperimente analog Beispiel 1 durchgeführt. Die Haftung und Integrität aufgedampfter Schichten war gut, das Material folglich zur Herstellung von Halbleiter-Bauelementen geeignet.

### Beispiel 2b

Der identische Ausgangsansatz von Beispiel 2a wurde unter zu Beispiel 2a identischen Bedingungen durch Warmpressen zu Substraten geformt, unter N₂-Spülung vernetzt und pyrolysiert. Im Unterschied zum Vorgehen gemäß Beispiel 1 und Beispiel 2a wurde durch Aufheizen auf 1370°C unter 95 bar N₂ nitridiert. Die Dichte und offene Porosität (s. Tabelle 1) ändern sich beim nitridierten Substrat dieser Ausführungsform gegenüber Beispiel 2a nur geringfügig, der Restgehalt an freiem Silicium fällt jedoch bereits nach nur ca. 50% der Reaktionsdauer gegenüber Beispiel 2a unter die röntgenografische Nachweisgrenze.

Es wurden Beschichtungsexperimente analog Beispiel 1 durchgeführt. Die Haftung und Integrität aufgedampfter Schichten war gut, das Material folglich zur Herstellung von Halbleiter-Bauelementen geeignet.

### Beispiel 3

Der identische Ausgangsansatz von Beispiel 2a wurde nicht wie in Beispiel 1 beschrieben in Isopropanol sondern in Hexan aufbereitet, wobei der Feststoffgehalt, bezogen auf die unlöslichen Pulverbestandteile 60 Gew.-% betrug. Die Homogenisierung erfolgte wie in Beispiel 1 beschrieben. Anschließend wurde nicht eingedampft sondern die Suspension direkt über ein Sieb mit der Maschenweite 50 µm abgesiebt, in Exsikkator unter Rühren entgast, auf 60°C erwärmt und auf einer Labor-Foliengießanlage verarbeitet. Hierbei resultierten sehr gleichmäßige Substrate hinsichtlich Dicke und Oberflächenbeschaffenheit, die entsprechend Beispiel 1 weiterbehandelt wurden.

Die resultierenden Kennwerte sind in Tabelle 1 zusammengestellt, sie entsprechen den erfindungsgemäßen Kriterien.

Es wurden Beschichtungsexperimente analog Beispiel 1 durchgeführt. Die Haftung und Integrität aufgedampfter Schichten war gut, das Material folglich zur Herstellung von Halbleiter-Bauelementen geeignet.

### Beispiel 4

900 g Silicium-Pulver, 500 g Methylsiloxan und 500 g Si₃N₄-Pulver gemäß Beispiel 2a, sowie zusätzlich 100 g Y₂O₃, 50 g Al₂O₃ und 70 g MgAl₂O₄, wobei die Zusätze Feinheiten mit mittleren Teilchengrössen < 1 µm und Reinheiten ≥ 98% aufwiesen, wurden analog Beispiel 1 aufbereitet und analog Beispiel 2a zu Substraten verarbeitet. Diese durch Nitridierung verfestigten Teile wurden zusätzlich bei 1750°C unter 2 bar N₂ gesintert, wodurch das Material weiter verfestigt wurde und keine offene Porosität mehr festgestellt werden konnte (Tabelle 1).

Die resultierenden Kennwerte sind in Tabelle 1 zusammengestellt, sie entsprechen den erfindungsgemäßen Kriterien.

Es wurden Beschichtungsexperimente analog Beispiel 1 durchgeführt. Die Haftung und Integrität aufgedampfter Schichten war gut, das Material folglich zur Herstellung von Halbleiter-Bauelementen geeignet.

### Beispiel 5

Zum identischen Ausgangsansatz von Beispiel 2 a wurden zusätzlich 40 g WC-Pulver mit einer mittleren Teilchengröße von < 2 µm und einer Reinheit ≥ 96% zugesetzt, die Materialien wie in Beispiel 1 beschrieben aufbereitet und wie in Beispiel 2a ausgeführt geformt und weiterverarbeitet. Es zeigte sich, dass das WC während der Nitridierung zu WSi₂ reagierte und das Substrat tief schwarz färbte.

Die resultierenden Kennwerte sind in Tabelle 1 zusammengestellt, sie entsprechen den erfindungsgemäßen Kriterien.

Es wurden Beschichtungsexperimente analog Beispiel 1 durchgeführt. Die Haftung und Integrität aufgedampfter Schichten war gut, das Material folglich zur Herstellung von Halbleiter-Bauelementen geeignet.

### Beispiel 6

Zum identischen Ausgangsansatz von Beispiel 2a wurden zusätzlich 700 g TiN-Pulver mit einer mittleren Teilchengröße < 2 µm und einem N-Gehalt von >20 Gew.-%, z.B. HCST-Grade C, zugesetzt. Diese Ausgangsstoffe wurden wie in Beispiel 1 beschrieben aufbereitet und wie in Beispiel 2a aufgeführt geformt und weiterverarbeitet, wobei als Nitridierungstemperatur abweichend von den genannten Beispielen 1380°C unter 1 bar N₂ gewählt wurde. Das TiN bildete im nitridierten Material eine Perkolationsstruktur aus, die eine hohe elektrische Leitfähigkeit von >1 S/m bewirkte. Ferner fördert es die Nitridierung. Selbst bei der im Vergleich zu Beispiel 1 und 2a niedrigeren Temperatur bei der Nitridierung war röntgenografisch in den Substraten kein freies Silicium nachweisbar.

Die resultierenden Kennwerte sind in Tabelle 1 zusammengestellt, sie entsprechen den erfindungsgemäßen Kriterien.

Es wurden Beschichtungsexperimente analog Beispiel 1 durchgeführt. Die Haftung und Integrität aufgedampfter Schichten war gut, das Material folglich zur Herstellung von Halbleiter-Bauelementen geeignet.

**Tabelle 1**

| **Beispiel:** | | **1** | **2a** | **2b** | **3** | **4** | **5** | **6** |
|---|---|---|---|---|---|---|---|---|
| Ausgangs-Zusammensetzung | | Si-Pulver, MPS* | Si-Pulver, SN-Pulver, MPS* | Si-Pulver, SN-Pulver, MPS* | Si-Pulver, SN-Pulver, MPS* | Si-Pulver, SN-Pulver, MPS*, Y₂O₃, Al₂O₃, MgAl₂O₄ | Si-Pulver, SN-Pulver, MPS*, WC | Si-Pulver, SN-Pulver, MPS*, TiN |
| Formgebung | | Trockenpressen | Warmpressen | Warmpressen | Foliengießen | Warmpressen | Warmpressen | Warmpressen |
| Schwindung | % | 0,8 | 1,5 | 1,5 | 2,5 | 4,8 | 1,8 | 3,4 |
| Dichte | g/cm³ | 2,25 | 2,55 | 2,60 | 2,48 | 3,04 | 2,58 | 2,78 |
| Offene Porosität | Vol.-% | 22 | 11 | 9 | 13 | 0 | 11 | 12 |
| Phasenbestand: | Si₃N₄ | vorh.¹ | vorh.¹ | vorh.¹ | vorh.¹ | vorh.¹ | vorh.¹ | vorh.¹ |
| | SiC | vorh.¹ | vorh.¹ | vorh.¹ | vorh.¹ | vorh.¹ | vorh.¹ | vorh.¹ |
| | Si₂N₂O | vorh.¹ | vorh.¹ | vorh.¹ | vorh.¹ | vorh.¹ | vorh.¹ | vorh.¹ |
| | weitere | -- | -- | -- | -- | Amorphe Phase | WSi-Phasen | TiN |
| Si-Gehalt | % | 6 | 2 | n.nw** | 2 | n.nw** | 2 | n.nw** |
| Anmerkungen | | | Standard-Nitridierung | Druck-Nitridierung | | Gesintert | | |
| **Erfindungsgemäß:** | | **nein** | **ja** | **ja** | **ja** | **ja** | **ja** | **ja** |
| | | *: Methylpolysiloxan ¹: vorhanden | | **n.nw: nicht nachweisbar | | | | |

### Beispiel 7 (Solarzellenherstellung)

Ein Siliciumnitridsubstrat, das gemäß Beispiel 4 hergestellt wurde, wurde zunächst mit einer Sperrschicht aus Siliciumoxid/ Siliciumnitrid/ Siliciumoxid mit den Dicken 1 µm, 0.1 µm und 1 µm versehen. Die Abscheidung der Sperrschicht erfolgte durch plasmaunterstützte chemische Gasphasenabscheidung. Die Substrattemperatur lag dabei bei 350°C. Zur Herstellung der Siliciumnitrid-Schicht wurde Silan und Stickstoff im Plasma über die Probe geleitet, zur Herstellung der SiliciumoxidSchichten Silan und Lachgas.

Das beschichtete Substrat wurde dann mittels einer chemischen Gasphasenabscheidung mit einer etwa 10 µm dicken feinkristallinen (Korngröße etwa 30 µm) Bor-dotierten Siliciumschicht versehen. Dazu wurde das mit der Sperrschicht beschichtete Substrat in einem CVD-Reaktor auf 950°C erhitzt und mit einer Gasmischung bestehend aus 10 1/min Wasserstoff, 10 g/min Trichlorsilan und 0.1 l/min Diboran behandelt.

Dann wurde ein Flüssigphasen-Rekristallisationssehritt zur Vergrößerung der Körner durchgeführt. Dazu wurde die Siliciumschicht bei 1420°C in einem schmalen Streifen von wenigen Millimetern bis zur Keramikoberfläche aufgeschmolzen und die flüssige Zone gleichmäßig mit etwa 10 mm/min über die Probe hinweggezogen. Am Rand des Substrates entstanden durch spontane Nukleation Kristallkeime, die dann zu einem lateralen Überwachsen der Zwischenschicht geführt haben. Die Körner hatten nach dem Umschmelzen einige Millimeter Breite und einige Zentimeter Länge. Diese umgeschmolzene Bor-dotierte Siliciumschicht wurde dann mit einer zweiten CVD-Abscheidung bei 1200°C und einer Gasmischung wie oben auf etwa 30 µm Schichtdicke verstärkt.

Aus dem so beschichteten Substrat wurden in bekannter Weise Dünnschichtsolarzellen hergestellt. Es wurde dabei so vorgegangen, dass in einem Diffusions-Rohrofen in die Bor-dotierte Siliciumschicht Phosphor bei 820°C eindiffundiert wurde. Nach der Diffusion wurde das entstandene Phosphorglas mit einer Flusssäure-haltigen Ätzmischung entfernt. Danach wurde eine Antireflexschicht bestehend aus Titandioxid und Magnesiumfluorid in einer Vakuumaufdampfanlage aufgebracht.

Anschließend wurde die Fläche der Solarzelle mittels Photolithographie auf 1 cm² festgelegt. Dabei wurde die Solarzelle durch einen Photolack geschützt, während die Fläche um die Solarzelle etwa 5 µm tief abgeätzt wurde, so dass die Bor-dotierte Schicht offen lag.

Auf die Vorderseite wurden nun Kontakte aufgedampft, so dass sowohl die Phosphor-dotierte als auch die Bor-dotierte Schicht kontaktiert wurde. Die Kontakte wurden anschließend bei einer Temperatur von etwa 650°C eingebrannt. Die Solarzelle erreichte einen Wirkungsgrad von 9.4 %.

## Patentansprüche

1. Verwendung eines Substrates auf Basis von Siliciumnitrid zur Herstellung von Halbleiterbauelementen oder Dünnschichtsolarzellen, wobei das Substrat aus einer kristallinen Phase besteht, das Siliciumnitrid (Si₃N₄), Siliciumcarbid (SiC) und Siliciumoxynitrid enthält (Si₂N₂O) und Sinteradditive in einer Gesamtkonzentration von < 20 Gew.-% enthält, wobei die Sinteradditive während der Herstellung eine flüssige Phase ausbilden und im Substrat als amorphe Sekundärphase oder als komplexere kristalline Nebenphasen vorliegen, und wobei der Gehalt an kristallinem Silicium ≤ 5 %, bezogen auf die Gesamtheit der vorliegenden kristallinen Phasen, die Schwindung bei der Herstellung < 5 % und die offene Porosität < 15 % beträgt.

2. Verwendung nach Anspruch 1, wobei es sich bei den Sinteradditiven um SiO₂, Erdalkali-Oxide, Oxide der Gruppe II B und IV B des Periodensystems, inklusive der Seltenen Erdoxide, V-, Nb-, Ta, Cr, Fe, Co- und/oder Ni-Oxid alleine oder in Kombination mit B₂O₃, Al₂O₃ und/oder TiO₂ handelt.

3. Verwendung nach Anspruch 1 oder 2, wobei das Substrat Carbide, Nitride, Carbonitride, Oxinitride, Silicide und/oder Boride der Elemente Si, Al, Ti, Zr, Hf, V, Nb, Ta, Cr, Mo, W, Mn, Fe, Ca, und/oder Ni in Konzentrationen < 10 Gew.-% berechnet als entsprechende Verbindung enthält, wobei der Gesamtanteil an diesen Bestandteilen 10 Gew.-% nicht überschreitet.

4. Verwendung nach mindestens einem der Ansprüche 1 bis 3, wobei das Substrat Carbide, Nitride, Carbonitride, Silicide und/oder Boride der Elemente Si, Ti, Zr, Hf, V, Nb, Ta, Cr, Mo, W, Mn und/oder Fe in Konzentrationen ≥ 30 Gew.-% enthält und eine elektrische Leitfähigkeit von ≥ 0,1 S/cm aufweist.

5. Verwendung nach Anspruch 3 oder 4, wobei die genannten Stoffe als anorganische Fasern, Whisker, Platelets oder Partikel eingebracht werden und/oder im Substrat in dieser Form vorliegen.

6. Verwendung nach einem oder mehreren der Ansprüche 1 bis 5, wobei das Substrat Kohlenstoff-Fasern enthält, die im Substrat also solche vorliegen oder teilweise oder vollständig zu komplexeren Verbindungen abreagiert sind.

7. Halbleiter-Bauelement oder Dünnschichtsolarzelle enthaltend ein Substrat nach einem oder mehreren der Ansprüche 1 bis 6.

8. Halbleiter-Bauelement oder Dünnschichtsolarzelle nach Anspruch 7, wobei auf dem Substrat eine oder mehrere kristalline Siliciumschichten abgeschieden sind.

9. Halbleiter-Bauelement oder Dünnschichtsolarzelle nach Anspruch 8, wobei zwischen dem Substrat und den Siliciumschichten eine oder mehrere zusätzliche Schichten aufgebracht werden.

10. Halbleiter-Bauelement oder Dünnschichtsolarzellenach Anspruch 9, wobei es sich bei den zusätzlichen Schichten um Siliciumnitrid-, Siliciumoxid- oder Siliciumcarbidschichten handelt.

## Claims

1. Use of a substrate based on silicon nitride for producing semiconductor components or thin-film solar cells, the substrate consisting of a crystalline phase containing silicon nitride (Si₃N₄), silicon carbide (SiC) and silicon oxynitride (Si₂N₂O) and containing sintering additives in a total concentration of < 20% by weight, the sintering additives forming a liquid phase during production and being present in the substrate as an amorphous secondary phase or as more complex additional crystalline phases, and the crystalline silicon content being ≤ 5%, based on the sum of the crystalline phases which are present, the shrinkage during production being < 5% and the open porosity being < 15%.

2. Use according to Claim 1, wherein the sintering additives are SiO₂, alkaline earth metal oxides, oxides from group II B and IV B of the periodic table including the rare earth metal oxides, oxides of V, Nb, Ta, Cr, Fe, Co and/or Ni oxide alone or in combination with B₂O₃, A_₂O₃ and/or TiO₂.

3. Use according to Claim 1 or 2, wherein the substrate contains carbides, nitrides, carbonitrides, oxynitrides, silicides and/or borides of the elements Si, Al, Ti, Zr, Hf, V, Nb, Ta, Cr, Mo, W, Mn, Fe, Ca and/or Ni in concentrations of < 10% by weight, calculated as the corresponding compound, the total content of these constituents not exceeding 10% by weight.

4. Use according to at least one of Claims 1 to 3, wherein the substrate contains carbides, nitrides, carbonitrides, silicides and/or borides of the elements Si, Ti, Zr, Hf, V, No, Ta, Cr, Mo, W, Mn and/or Fe in concentrations of ≥ 30% by wight and has an electrical conductivity of ≥ 0,1 S/cm.

5. Use according to Claim 3 or 4, wherein the abovementioned substances are introduced as inorganic fibers, whiskers, platelets or particles and/or are present in this form in the substrate.

6. Use according to one or more of Claims 1 to 5, wherein the substrate contains carbon fibers which are present as such in the substrate or have partially or completely reacted to form more complex compounds.

7. Semiconductor component or thin-film solar cell which includes a substrate according to one or more of Claims 1 to 6.

8. Semiconductor component or thin-film solar cell according to Claim 7, wherein one or more crystalline silicon layers are deposited on the substrate.

9. Semiconductor component or thin-film solar cell according to Claim 8, wherein one or more additional layers are applied between the substrate and the silicon layers.

10. Semiconductor component or thin-film solar cell according to Claim 9, wherein the additional layers are silicon nitride, silicon oxide or silicon carbide layers.

## Revendications

1. Utilisation d'un substrat à base de nitrure de silicium pour la fabrication de composants semiconducteurs ou de cellules solaires en couches minces, le substrat étant constitué d'une phrase cristalline qui contient du nitrure de silicium (Si₃N₄), da carbure de silicium (SiC) et de l'oxynitrure de silicium (Si₂N₂O) et qui contient des additifs de frittage en une concentration totale < 20 % on poids, les additifs de frittage formant une phase liquide pendant la fabrication et se présentant dans le substrat sous la forme d'une phase secondaire amorphe ou sous la forme de phases secondaires cristallines plus complexes, et la teneur en silicium cristallin étant ≤ 5 % par rapport à la totalité des phases cristallines présentes, le retrait lors de la fabrication étant < 5 et la porosité ouverte étant < 15 %.

2. Utilisation selon la revendication 1, dans laquelle les additifs de frittage sont SiO₂, des oxydes alcalino-terreux, des oxydes du groupe IIB et IVB du tableau périodique, y compris les oxydes de terres rares, un oxyde de V, Nb, Ta, Cr, Fe, Co et/ou Ni, seul ou en combinaison avec B₂O₃, Al₂O₃ et/ou TiO₂.

3. Utilisation selon la revendication 1 ou 2, dans laquelle le substrat contient des carbures, nitrures, carbonitrures, oxynitrures, siliciures et/ou borures des éléments Si, Al, Ti, Zr, Ilf, V, Nb, Ta, Cr, Mo, W, Mn, Fe, Ca et/ou Ni en concentrations < 10 % en poids, calculées en tant que composé correspondant, la proportion totale de ces constituants ne dépassant pas 10 en poids.

4. Utilisation selon au moins l'une quelconque des revendications 1 à 3, dans laquelle le substrat contient des carbures, nitrures, carbonitrures, siliciures et/ou borures des éléments Si, Ti, Zr, Hf, V, Nb, 'l'a, Car, Mo, W, Mn et/ou Fe en concentrations ≥ 30% en poids et présente une conductivité électrique ≥ 0,1 S/cm.

5. Utilisation selon la revendication 3 ou 4, dans laquelle les substances citées sont introduites sous la forme de particules, paillettes, barbes ou fibres inorganiques, moustaches, et/ou se présentent sous cette forme dans le substrat.

6. Utilisation selon une ou plusieurs des revendications 1 à 5, dans laquelle le substrat contient des fibres de carbone qui sont présentes dans le substrat en tant que telles ou transformées en partie ou en totalité en composés plus complexes.

7. Composant semi-conducteur ou cellule solaire en couches minces contenant un substrat selon une ou plusieurs des revendications 1 à 6.

8. Composant semi-conducteur ou cellule solaire en couches minces selon la revendication 7, dans lequel ou dans laquelle une ou plusieurs couches de silicium cristallin sont déposées sur le substrat.

9. Composant semi-conducteur ou cellule solaire en couches minces selon la revendication 8, dans lequel ou dans laquelle une ou plusieurs couches supplémentaires sont appliquées encore le substrat et les couches de silicium.

10. Composant semi-conducteur ou cellule solaire en couches minces selon la revendication 9, dans lequel ou dans laquelle les couches supplémentaires sont des couches de nitrure de Silicium, d'oxyde de silicium ou de carbure de silicium.
